# EUROPEAN PATENT APPLICATION

(11) **EP 4 471 810 A1**
(43) Date of publication of application: **04.12.2024**
(21) Application number: 23746880.6
(22) Date of filing: 23.01.2023
(51) Int. Cl.: H01B 1/22, H01B 1/00, H01L 31/0224, H10K 30/50

(54) **CONDUCTIVE COMPOSITION, CONDUCTIVE PASTE, CURED PRODUCT AND SOLAR CELL**

(30) Priority: 28.01.2022 JP 2022011966
(71) Applicant: Namics Corporation, Niigata-shi, Niigata 950-3131 (JP)
(72) Inventor: KOBAYASHI Kenji, Niigata-shi, Niigata 950-3131 (JP); MATSUBARA Mitsuaki, Niigata-shi, Niigata 950-3131 (JP)
(74) Representative: Hoffmann Eitle
(86) International application number: PCT/JP2023/001829
(87) International publication number: WO 2023/145668

(57) **Abstract**

A conductive composition for forming an electrode having a low specific resistance at a low temperature.

A conductive composition comprising conductive particles, a solvent (B), and an epoxy resin (C), wherein the epoxy resin (C) has a concentration of easily saponifiable chlorine of 1600 ppm or more, and the epoxy resin (C) is 1.2 to 10 parts by weight based on 100 parts by weight of the conductive particles (A).

## Description

### FIELD OF THE INVENTION

The present invention relates to a conductive composition and a conductive paste capable of obtaining a conductive pattern excellent in electrical characteristics. More specifically, the present invention relates to a conductive composition and a conductive paste that can be used for forming electrodes of a semiconductor device such as a solar cell.

### BACKGROUND ART

Conductive pastes containing conductive particles such as silver particles are used, for example, for forming electrodes and circuit patterns of semiconductor devices and electronic components. Formation of an electrode and a circuit pattern by the conductive paste can be performed by applying a conductive paste of a predetermined pattern on a substrate or the like by a screen printing method or the like, and then heating the conductive paste to obtain a conductive film of the predetermined pattern.

There are two types of conductive paste, i.e., a high-temperature firing type conductive paste and a thermosetting type conductive paste. The high-temperature firing type conductive paste is a paste that can form a conductive film by being fired at a high temperature of about 550 to 900 degrees C. In the case of the high-temperature firing type conductive paste, the resin component contained in the conductive paste is burned off during the firing. The thermosetting type conductive paste is a paste that can form a conductive film by heating at a relatively low temperature of a room temperature (about 20 degrees C) to 250 degrees C. In the case of the thermosetting type conductive paste, the resin component is cured and silver particles are bonded to each other to form a conductive film.

As the thermosetting type conductive paste, Patent Document 1 discloses a conductive paste for forming an electrode of a solar cell, which contains (A) a conductive component, (B) an epoxy resin, (C) an imidazole and (D) a solvent. Further, Patent Document 1 discloses that an amount of (C) the imidazole in the conductive paste is 0.1 to 1.0% by weight based on 100% by weight of the conductive paste excluding (D) the solvent.

As an example of a solar cell, Patent Document 2 discloses a perovskite solar cell. The perovskite solar cell of Patent Document 2 comprises a substrate, a first electrode provided on the substrate, an electron transport layer including an electron transporting compound provided on the first electrode, a perovskite compound layer including a perovskite compound provided on the electron transport layer, a hole transport layer including a hole transport compound provided on the perovskite compound layer, and a second electrode provided on the hole transport layer. The perovskite compound contained in the perovskite solar cell of Patent Document 2 is expressed as a general formula X_{α}Y_{β}M_{γ}. In the general formula, X is a halogen atom, Y is an alkylamine compound, M includes a mixture of lead and antimony, and the ratio of α : β : γ is 3 : 1 : 1. Patent Document 2 discloses that the metal oxide is any of zinc oxide, tin oxide, titanium oxide, aluminum oxide, niobium oxide, yttrium oxide, and barium titanate.

### Prior Art Documents

### Patent Documents

Patent document 1: JP 2019-102719 A
Patent document 2: JP 2015-191913 A

### DISCLOSURE OF THE INVENTION

Thermosetting conductive paste generally uses epoxy resin as a binder. In order to achieve both good adhesion and good electrical property, heat treatment at more than 200 degrees C is generally required.

Thermosetting conductive paste is sometimes used for forming an electrode of a solar cell. In order to obtain solar cells with high conversion efficiency, it is necessary to reduce a width of the electrode and an electrical resistance of the electrode. By reducing the width of the electrode formed on the surface where sunlight is incident, the incident area of sunlight can is increased. By reducing the width of the electrode, the electrical resistance of the electrode is increased. Therefore, in order to obtain a solar cell with high conversion efficiency, it is necessary to reduce the specific resistance of the electrode. Further, by narrowing the width of the electrode, the contact area between the electrode and a main body of the solar cell becomes smaller. Therefore, in order to obtain a solar cell with high conversion efficiency, it is necessary to lower the contact resistance between the electrode and the main body of the solar cell.

In recent years, the development of a perovskite solar cell as described in Patent Document 2 has been advanced. Since the perovskite compound layer of the perovskite solar cell is weak against high temperature, it is known that the performance of the perovskite solar cell deteriorates when it is heated. In order to suppress the deterioration of the performance of the perovskite solar cell, the heating temperature at the time of forming the electrode is required to be 150 degrees C or lower. Therefore, in the case of the perovskite solar cell, it is necessary to form the electrode at a lower temperature (for example, 150 degrees C or lower) than the conventional one.

Therefore, an object of the present invention is to provide a conductive composition for forming an electrode having a low specific resistance at a low temperature. Specifically, an object of the present invention is to provide a conductive composition for forming an electrode of a perovskite solar cell having a low specific resistance at a low temperature.

In order to solve the above problem, the present invention has the following configurations.

### (Configuration 1)

Configuration 1 is a conductive composition comprising:
conductive particles (A);
a solvent (B); and
an epoxy resin (C),
wherein the epoxy resin (C) has a concentration of easily saponifiable chlorine of 1600 ppm or more, and
the epoxy resin (C) is 1.2 to 10 parts by weight based on 100 parts by weight of the conductive particles (A).

### (Configuration 2)

Configuration 2 is the conductive composition of the configuration 1, wherein the conductive particles (A) comprises conductive particles A1 and conductive particles A2, and an average particle size of the conductive particles A2 is larger than an average particle size of the conductive particles A1.

### (Configuration 3)

Configuration 3 is the conductive composition of the configuration 2, wherein the average particle size of the conductive particles A2 is 1.5 to 4.5 µm.

### (Configuration 4)

Configuration 4 is the conductive composition of the configuration 2 or 3, wherein
an average particle size of the conductive particles A1 is 0.05 to 1.4 µm, and
an average particle size of the conductive particles A2 is 2.0 to 3.5 µm.

### (Configuration 5)

Configuration 5 is the conductive composition of any one of the configurations 2 to 4, wherein the conductive particles (A) comprise 0 to 40 weight % of the conductive particles A1 and 40 to 90 weight % of the conductive particles A2 in 100 weight % of the conductive particles (A).

### (Configuration 6)

Configuration 6 is the conductive composition of any one of the configurations 2 to 5, wherein the conductive particles A1 have a BET specific surface area of 0.3 to 3.5 m²/g.

### (Configuration 7)

Configuration 7 is the conductive composition of any one of the configurations 2 to 6, wherein the conductive particles A2 have a BET specific surface area of 0.1 to 0.4 m²/g.

### (Configuration 8)

Configuration 8 is the conductive composition of any one of the configurations 2 to 7, wherein the conductive particles (A1) and the conductive particles (A2) are spherical conductive particles.

### (Configuration 9)

Configuration 8 is the conductive composition of any one of the configurations 1 to 8, wherein the conductive composition further comprises a curing agent (D).

### (Configuration 10)

Configuration 10 is a conductive composition of the configuration 9, wherein the curing agent (D) comprises a compound of the structure of formula (a).

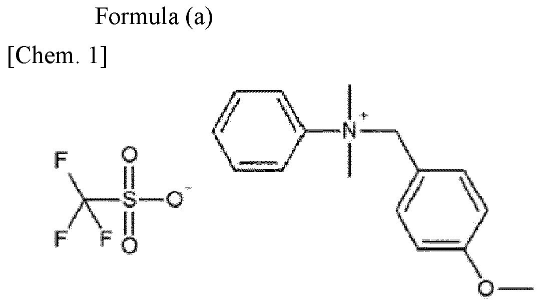

### (Configuration 11)

Configuration 11 is a conductive paste for forming an electrode of a solar cell, wherein the conductive paste comprises the conductive composition of any one of the configurations 1 to 10.

### (Configuration 12)

Configuration 12 is a conductive paste for forming an electrode of a perovskite solar cell, wherein the conductive paste comprises the conductive paste of the configuration 11.

### (Configuration 13)

Configuration 13 is a cured product of the conductive composition of any one of the configurations 1 to 10, or a cured product of the conductive paste of the configuration 11 or 12.

### (Configuration 14)

Configuration 14 is a solar cell comprising the cured product of the configuration 13.

According to the present invention, a conductive composition for forming an electrode having a low specific resistance at a low temperature can be provided. Specifically, according to the present invention, a conductive composition for forming an electrode of a perovskite solar cell having a low specific resistance at a low temperature can be provided.

### BRIEF DESCRIPTION OF THE DRAWINGS

[Fig. 1] Fig. 1 is a cross-sectional schematic diagram illustrating an example of a perovskite solar cell.
[Fig. 2] Fig. 2 is a cross-sectional schematic diagram illustrating an example of a tandem solar cell including a perovskite solar cell.
[Fig. 3] Fig. 3 is a plan diagram illustrating a pattern for measuring specific resistance for an electrode formed using a conductive composition (a conductive paste).
[Fig. 4] Fig. 4 is a plan diagram illustrating a pattern for measuring a contact resistance for an electrode formed using a conductive composition (a conductive paste).

### MODE FOR CARRYING OUT THE INVENTION

Embodiments of the present invention will be specifically described below. The following embodiments are embodiments for embodying the present invention, and the present invention is not limited to the scope thereof.

The conductive composition of the present embodiment is a thermosetting conductive composition. The conductive composition of the present embodiment, which contains predetermined components, can be thermally cured at a low temperature (for example, 150 degrees C or lower) to form an electrode. The conductive composition of the present embodiment can be used as a conductive paste. By using the conductive composition (the conductive paste) of the present embodiment, a conductive film (an electrode) having a low specific resistance can be formed. The conductive composition of the present embodiment can be preferably used as a conductive paste for forming an electrode of a solar cell. The conductive composition of the present embodiment can be preferably used especially as a conductive paste for forming an electrode of a perovskite solar cell.

In the present specification, the term "a conductive film" refers to a thin-film-shaped pattern in which a conductive paste is printed or the like on a surface of a predetermined substrate or the like to form a pattern of a predetermined shape and cured. The pattern of the predetermined shape includes patterns of arbitrary shapes, for example, a linear shape, a dot shape and a planar shape. The conductive film can be used as an electrode.

Next, the conductive composition of the present embodiment will be described.

The conductive paste for forming the solar cell electrode of the present embodiment includes conductive particles (A), a solvent (B), and an epoxy resin (C). The conductive paste of the present embodiment can further include a curing agent (D) and other additives. Hereinafter, each component included in the conductive paste of the present embodiment will be described.

### <Conductive particles (A)>

The conductive composition of the present embodiment includes conductive particles (A).

As the conductive component contained in the conductive particles (A), a metal such as silver, copper, nickel, aluminum, zinc and/or tin can be used. The conductive component is preferably silver, and more preferably the conductive component consists of silver, because of its relatively low specific resistance and easy availability. More preferably, the conductive component consists of silver only. Therefore, it is preferable that the conductive particles (A) consist only of silver particles.

In the conductive particles (A), the expression "the conductive component consists of silver only" means that substantially all of the conductive component is silver except for the inevitable presence of impurities. That is, when the conductive component is consisting of silver only, the conductive component can contain inevitable presence of impurities other than silver. The same applies to other components other than the conductive component.

The average particle size of the conductive particles (A) is preferably 0.05 µm to 15 µm, more preferably 0.1 µm to 5 µm, and further more preferably 0.2 µm to 3 µm. In the present specification, the average particle size refers to the average particle size based on the number criterion by laser diffraction scattering particle size distribution measurement (average particle size of 50% integrated value of all particles: D50). When the average particle size of the conductive particles is within the above range, the surfaces of the electrodes and circuit patterns obtained by heating the conductive composition (the conductive paste) are in good condition. In addition, the electrical characteristics of the electrodes and circuit patterns obtained by heating the conductive composition (the conductive paste) can be improved.

In the conductive composition of the present embodiment, it is preferable that the conductive particles (A) include conductive particles A1 and conductive particles A2, and the average particle size of the conductive particles A2 is larger than the average particle size of the conductive particles A1. Since the conductive particles (A) included in the conductive composition of the present embodiment include two kinds of conductive particles A1 and A2 having predetermined average particle sizes, an electrode having a low specific resistance can be formed using the conductive composition of the present embodiment. In addition, since the conductive particles (A) include two kinds of conductive particles A1 and A2 having predetermined average particle sizes, the contact resistance between a conductive film (electrode) formed using the conductive composition and a substrate (it is sometimes simply referred to as "contact resistance".) can be lowered.

In the conductive composition of the present embodiment, the average particle size of the conductive particles A2 is preferably 1.5 to 4.5 µm, and more preferably 2.0 to 3.5 µm. When the average particle size of the conductive particles A2 is within the predetermined range, a conductive composition for forming electrodes having low specific resistance and low contact resistance at low temperature can be more reliably obtained.

In the conductive composition of the present embodiment, the average particle size of the conductive particles A1 is preferably 0.05 to 1.4 µm, and the average particle size of the conductive particles A2 is preferably 2.0 to 3.5 µm. The average particle size of the conductive particles A1 is more preferably 0.1 to 1.0 µm, and further more preferably 0.2 to 0.8 µm. The average particle size of the conductive particles A2 is more preferably 2.2 to 3.3 µm, and further more preferably 2.4 to 3.0 µm. Since the average particle sizes of the conductive particles A1 and A2 are both within the predetermined ranges, a conductive composition for forming an electrode having low specific resistance and low contact resistance at a low temperature can be more reliably obtained.

The conductive composition of the present embodiment can further include conductive particles A3 having an average particle size of 0.6 to 1.4 µm as the conductive particles (A). When the conductive composition includes conductive particles A3 in addition to the conductive particles A1 and A2, it can be further ensured that an electrode having a low specific resistance and low contact resistance at a low temperature is formed.

In order to obtain an electrode having a lower specific resistance, it is preferable that the conductive particles A1, A2 and A3 are all silver particles.

The particle size of the conductive particles generally shows a distribution close to a normal distribution. When there are two kinds of conductive particles A1 and A2 having different average particle sizes in the conductive particles (A), there are two kinds of normal distributions corresponding to the particle size distributions of the conductive particles A1 and A2. Therefore, when two kinds of conductive particles A1 and A2 coexist, it is possible to measure the average particle size (D50) of the two kinds of conductive particles A1 and A2 by measuring the particle size distribution by laser diffraction scattering particle size distribution measurement and performing peak separation assuming that the peaks corresponding to the two kinds of conductive particles A1 and A2 are normal distributions. When there are two kinds of conductive particles A1 and A2 having different average particle sizes, the particle size distribution measured by laser diffraction scattering particle size distribution measurement can have two peaks capable of peak separation. Similarly, when there are three kinds of conductive particles A1, A2 and A3, the particle size distribution measured by laser diffraction scattering particle size distribution measurement can have three peaks capable of peak separation.

The conductive composition of the present embodiment preferably contains 0 to 40 weight %, more preferably 10 to 35 weight %, and further more preferably 15 to 30 weight % of the conductive particles A1 in 100 weight % of the conductive particles (A). The conductive composition of the present embodiment preferably contains 40 to 90 weight %, more preferably 50 to 85 weight %, and further more preferably 60 to 80 weight % of the conductive particles A2 in 100 weight % of the conductive particles (A). When the contents of the conductive particles A1 and A2 in the conductive particles (A) are within the predetermined range, the conductive composition for forming an electrode having low specific resistance and low contact resistance at low temperature can be more reliably obtained.

The shape of the conductive particles can be, for example, spherical, flake, needle, or the like. Conductive particles having different shapes can be mixed and used. The flake conductive particles can be produced, for example, by crushing spherical conductive particles by ball milling or the like.

Further, in the case of the conductive composition (the conductive paste) for forming the electrode with fine wiring (for example, the wiring width is 20 to 60 µm.), both the conductive particles A1 and A2 are preferably spherical conductive particles, and the conductive particles (A) are particularly preferably substantially composed of spherical conductive particles. By using spherical conductive particles having different average particle sizes, it can be further ensured that the electrodes having low specific resistance and low contact resistance can be formed at low temperature. Furthermore, since the spherical conductive particles are easier to control in particle size and have fewer coarse particles than silver particles having a flaky shape, the electrode with fine wiring can be advantageously formed by using the spherical conductive particles.

In the conductive composition of the present embodiment, a BET specific surface area of the conductive particles (A) is preferably 0.3 to 3.5 m²/g, more preferably 0.3 to 3 m²/g, and more preferably 0.4 to 2.5 m²/g. By setting the BET specific surface area of the conductive particles (A) in an appropriate range, an electrical characteristics of an electrode and a circuit pattern obtained by heating the conductive composition (the conductive paste) are improved.

In the conductive composition of the present embodiment, a BET specific surface area of the conductive particles A1 is preferably 0.3 to 3.5 m²/g, more preferably 0.5 to 3.0 m²/g, and further more preferably 1.0 to 2.5 m²/g. In the conductive composition of the present embodiment, a BET specific surface area of the conductive particles A2 is preferably 0.1 to 0.4 m²/g, more preferably 0.15 to 0.35 m²/g, and further more preferably 0.2 to 0.3 m²/g. By setting the BET specific surface area of the conductive particles A1 and A2 in the predetermined range, the conductive composition for forming electrodes having low specific resistance and low contact resistance at low temperature can be more reliably obtained.

The tap density of the conductive particles is preferably 2.0 to 8.0 g/cm³, more preferably 2.5 to 7.0 g/cm³, and particularly preferably 3.0 to 6.5 g/cm³. When the tap density is in this range, an electrode having sufficient conductivity can be formed.

The production method for producing the conductive particles (e.g., silver particles) composed of a conductive component is not particularly limited. As the production method, for example, a reduction method, a pulverization method, an electrolysis method, an atomization method, a heat treatment method, or a combination thereof can be used.

The conductive particles (A) are preferably surface-treated so that the surface of the conductive particles contains carboxylic acid, preferably at least one selected from stearic acid and oleic acid.

When the conductive particles (A) contain the predetermined organic substance, it is preferable that the conductive particles (A) in the conductive composition of the present embodiment contain spherical conductive particles (conductive particles with spherical shapes). The weight ratio of the spherical conductive particles in the conductive particles (A) is preferably 80 weight % or more, more preferably 90 weight % or more, further more preferably 95 weight % or more, and still more preferably 99 weight % or more. It is particularly preferable that the conductive particles (A) containing the organic component consist substantially of spherical conductive particles. When spherical conductive particles are used, the possibility of disconnection of the electrode can be reduced as compared with the case where conductive particles having scale-like (flake-like) shapes are used. On the other hand, it is generally known that when spherical conductive particles are used, a specific resistance is relatively high. When the conductive particles (A) contain the predetermined organic component due to surface treatment or the like, an electrode having a low specific resistance and a reduced possibility of disconnection can be formed in spite of the conductive particles (A) having the spherical shapes.

The content of the conductive particles (A) contained in the conductive composition of the present embodiment is preferably 75 to 99 weight %, more preferably 80 to 96 weight %, and further more preferably 85 to 95 weight % with respect to the whole conductive composition.

### <Solvent (B)>

The conductive composition of the present embodiment preferably further contains a solvent (B). When the conductive composition contains the solvent, the viscosity of the conductive composition (the conductive paste) can be set in an appropriate range, and performance of screen printing can be enhanced.

As examples of the solvent contained in the conductive composition of the present embodiment, aromatic hydrocarbons such as toluene, xylene, mesitylene and tetralin; ethers such as tetrahydrofuran; ketones such as methyl ethyl ketone, methyl isobutyl ketone, cyclohexanone and isophorone; lactams such as 2-pyrrolidone and 1-methyl-2-pyrrolidone; ether alcohols such as ethyl glycol monophenyl ether, ethylene glycol monomethyl ether, ethylene glycol monoethyl ether, ethylene glycol monobutyl ether, diethylene glycol monomethyl ether, diethylene glycol monoethyl ether, diethylene glycol monobutyl ether (butyl carbitol), and propylene glycol derivatives corresponding to the above ethers; esters, such as acetate esters, corresponding to the above ethers (for example, diethylene glycol monobutyl ether acetate); and diesters such as methyl esters or ethyl esters of dicarboxylic acids such as malonic acid and succinic acid can be mentioned. Among them, at least one selected from ethylene glycol monophenyl ether, diethylene glycol monobutyl ether and butyl carbitol acetate can be preferably used.

The conductive composition of the present embodiment preferably contains ethylene glycol monophenyl ether, diethylene glycol monobutyl ether (butyl carbitol), and/or diethylene glycol monobutyl ether acetate (butyl carbitol acetate) as the solvent (B).

When the solvent (B) contains ethylene glycol monophenyl ether, diethylene glycol monobutyl ether (butyl carbitol), and/or diethylene glycol monobutyl ether acetate (butyl carbitol acetate), it is possible to more reliably obtain a conductive film (e.g., an electrode of a solar cell) having a low specific resistance. Further, by using the predetermined solvent, the viscosity of the conductive composition (the conductive paste) can be further appropriately adjusted, and the printing characteristics of the printed conductive film can be improved. Specifically, when a pattern of the conductive film has a thin line shape, the line width can be made narrow and constant, the film thickness can be made constant, and the shape can be formed with a high aspect ratio.

When the conductive composition (the conductive paste) of the present embodiment is applied to a surface of a transparent conductive film or the like by screen printing, the apparent viscosity of the conductive composition (the conductive paste) at room temperature is preferably 100 to 1000 Pa·s, more preferably 200 to 900 Pa·s, and further more preferably 300 to 800 Pa s. The viscosity can be measured at a rotational speed of 5 rpm (shear speed: 2 sec⁻¹⁾ and a temperature of 25 degrees C using a Brookfield viscometer: HBD type (manufactured by Brookfield Corporation). The viscosity of the conductive composition (the conductive paste) can be set to a predetermined range by adjusting the mixing amount of solvent (B) in the conductive composition (the conductive paste).

### <Epoxy resin (C)>

The conductive composition of the present embodiment includes an epoxy resin (C).

The epoxy resin (C) contained in the conductive composition of the present embodiment has a concentration of easily saponifiable chlorine of 1600 ppm or more. The conductive composition of the present embodiment includes 1.2 to 10 parts by weight of epoxy resin (C) based on 100 parts by weight of conductive particles (A).

The present inventors have found a problem that, in the case that the concentration of the easily saponifiable chlorine of the epoxy resin (C) contained in the conductive composition of the present embodiment is low, the specific resistance of a conductive film (an electrode) formed using the conductive composition increases when the conductive composition is heat-treated at a low temperature (for example, 150 degrees C or lower) to form the electrode. Based on this finding, the present inventors further considered the relationship between the concentration of the easily saponifiable chlorine of epoxy resin (C) and the specific resistance of the conductive film (the electrode). As a result, it was found that, by including the predetermined amount of epoxy resin (C) having an concentration of easily saponifiable chlorine of 1600 ppm or more, an electrode having a specific resistance suitable for use as an electrode of a solar cell (especially a perovskite solar cell) can be formed by heat treatment at a low temperature (for example, 150 degrees C or less).

The easily saponifiable chlorine is generated as an impurity in the manufacturing process of an epoxy resin, as will be described later. In the manufacturing process of thermosetting resins such as (meth) acrylates, bismaleimides, phenolic resins, and silicone resins, the easily saponifiable chlorine is usually not generated.

As described above, the content of the epoxy resin (C) in the conductive composition is 1.2 to 10 parts by weight based on 100 parts by weight of conductive particles (A). The content of the epoxy resin (C) can be appropriately adjusted according to the value of a concentration of the easily saponifiable chlorine of the epoxy resin. The epoxy resin (C) may have a concentration of the easily saponifiable chlorine of 1600 ppm or more. When the conductive composition contains two or more kinds of epoxy resin (C), the epoxy resin having a concentration of the easily saponifiable chlorine of less than 1600 ppm and the epoxy resin having a high concentration of the easily saponifiable chlorine can be used together to adjust the total concentration of the easily saponifiable chlorine of epoxy resin (C) to 1600 ppm or more.

The "easily saponifiable chlorine" means "chlorine species present as 1,2-chlorohydrin that is generated when dehydrochlorination is incomplete". Examples of the easily saponifiable chlorine include 1,2-chlorohydrin form, 1,3-chlorohydrin form, and 1-chloromethyl-2-glycidyl ether form (chloromethyl form), and the like. The easily saponifiable chlorine is usually generated as an impurity in the manufacturing process of an epoxy resin.

Examples of the 1,2-chlorhydrin form include compounds represented by general formula (1). Examples of the 1,3-chlorhydrin form include compounds represented by general formula (2). Examples of the chloromethyl form include compounds represented by general formula (3). In general formulas (1) to (3) below, R^{1,} R², R³ and R⁴ are each independently a hydrogen atom or a methyl group. n is an integer of 0 to 30, n is preferably 0 to 20, and more preferably n is 0 to 10.

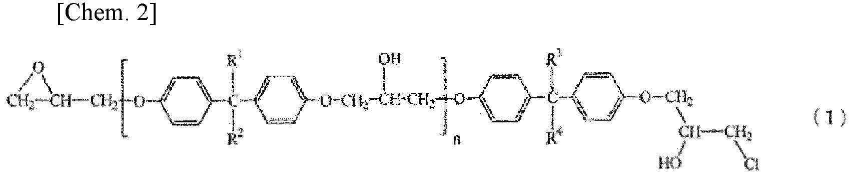

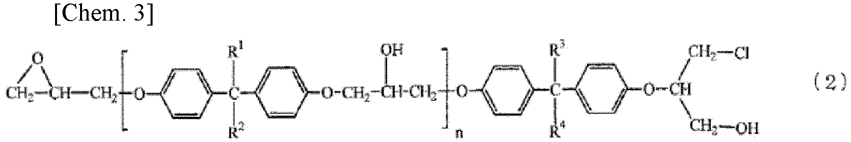

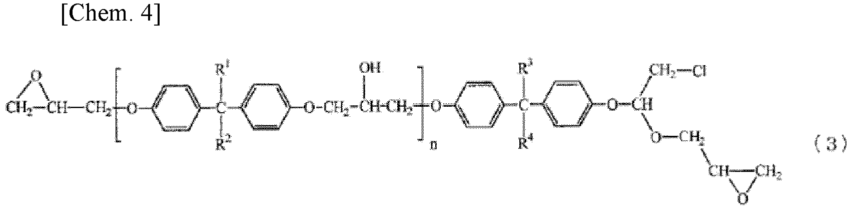

A kind of epoxy resin (C) is not particularly limited, and known epoxy resins can be used. Examples of the epoxy resin (C) include epoxy resins such as bisphenol A type, bisphenol F type, biphenyl type, tetramethylbiphenyl type, cresol novolak type, phenol novolak type, bisphenol A novolak type, dicyclopentadiene phenol condensation type, phenol aralkyl condensation type, glycidylamine type and the like, brominated epoxy resins, cycloaliphatic epoxy resins, and aliphatic epoxy resins. These epoxy resins can be used alone or in a mixture of two or more kinds.

Examples of the epoxy resin (C) include "AK -601 (trade name)" manufactured by Nippon Kayaku Co., Ltd. The concentration of the easily saponifiable chlorine of "AK -601" is about 6000 ppm. The concentration of the easily saponifiable chlorine described above is a measured value, and the method of measurement will be described later. These epoxy resins can be used alone or in a mixture of two or more kinds.

Although known epoxy resins (C) can be used as the epoxy resin, it is preferable to use an epoxy resin that is liquid at ordinary temperature. Among the epoxy resins that are liquid at ordinary temperature, it is preferable that the epoxy resin (C) contains a compound having a structure represented by formula (4) below. The compound having the structure of formula (4) is diglycidyl 1,2-cyclohexanedicarboxylate. By including the compound having the structure of formula (4), an electrode having a low specific resistance can be more reliably formed by heat treatment at a low temperature (for example, 150 degrees C or lower).

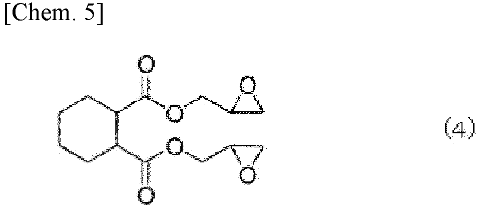

The concentration of the easily saponifiable chlorine of the epoxy resin (C) is 1600 ppm or more. The concentration of the easily saponifiable chlorine of the epoxy resin (C) is preferably 2000 to 50000 ppm, more preferably 2500 to 30000 ppm, further more preferably 3000 to 25000 ppm, and particularly preferably 3200 to 23000 ppm. When the concentration of the easily saponifiable chlorine is lower than the predetermined concentration, there arises a problem that a specific resistance of the conductive film (electrode) formed by heat treatment at a low temperature (for example, 150 degrees C or lower) increases. When the concentration of the easily saponifiable chlorine is higher than the predetermined concentration, there arises a problem that a contact resistance between a conductive film (an electrode) formed by heat treatment at a low temperature (for example, 150 degrees C or lower) and a conductive layer of the base material (for example, a transparent conductive film such as ITO) increases. From the viewpoint of lowering both the specific resistance and the contact resistance by heat treatment at a low temperature, the concentration of the easily saponifiable chlorine of the epoxy resin is preferably 3000 to 10000 ppm, more preferably 4000 to 9000 ppm, and further more preferably 5000 to 8000 ppm. In particular, in order to form an electrode having a specific resistance and a contact resistance that can be suitably used as an electrode of a solar cell (particularly a perovskite solar cell) at a low temperature (for example, 150 degrees C or lower), the concentration of the easily saponifiable chlorine of the epoxy resin (C) is preferably within the above predetermined range. When the conductive composition contains two or more kinds of epoxy resins (C), the total concentration of the easily saponifiable chlorine of the epoxy resins is preferably within the above predetermined range.

In the conductive composition of the present embodiment, the weight ratio of the epoxy resin (C) to 100 parts by weight of the conductive particles (A) is 1.2 to 10 parts by weight. The weight ratio of the epoxy resin (C) to 100 parts by weight of the conductive particles (A) is preferably 1.3 to 9 parts by weight, more preferably 1.4 to 8 parts by weight, and further more preferably 1.5 to 7.5 parts by weight. When the weight ratio of the epoxy resin (C) to 100 parts by weight of the conductive particles (A) is more than 10 parts by weight, the amount of the epoxy resin (C) becomes large with respect to the conductive particles (A), and sintering inhibition may easily occur. On the other hand, when the weight ratio of the epoxy resin (C) to 100 parts by weight of the conductive particles (A) is less than 1.2 parts by weight, it may be difficult to maintain the strength as an electrode.

The following methods may be used for measuring the concentration of the easily saponifiable chlorine of the epoxy resin (C). First, 25 mL of 2-butanone is added to 1 g of the epoxy resin (C) to be measured and dissolved. Then, 25 mL of 2-butoxyethanol is added to the obtained solution. Next, 25 mL of 1 mol/L sodium hydroxide solution is added to the obtained solution and mixed. Next, the obtained solution is allowed to stand at a room temperature of 25 degrees C for 60 minutes. Next, 25 mL of acetic acid is added to the solution which has been allowed to stand for 60 minutes and mixed to obtain a sample solution. Then, a silver electrode for potentiometric measurement is immersed in the obtained sample solution, and potentiometric titration is performed with 0.01 mol/L silver nitrate solution to obtain the concentration of the easily saponifiable chlorine of the epoxy resin (C) to be measured.

### <Curing agent (D)>

The conductive composition of the present embodiment preferably further contains a curing agent (D). By containing the curing agent (D), curing of the epoxy resin (C) can be appropriately controlled.

Known curing agents (D) can be used as the curing agent. The curing agent (D) preferably contains at least one selected from a phenolic curing agent, a cationic polymerization initiator, an imidazole curing agent, and a boron trifluoride compound. Examples of the boron trifluoride compound include boron trifluoride monoethylamine, boron trifluoride piperidine, boron trifluoride diethyl ether, and the like.

The conductive composition of the present embodiment preferably contains a compound having a structure of formula (a) as the curing agent (D). The compound having the structure of the formula (a) is a cationic polymerization initiator. Since the curing agent (D) is the compound having the structure of the formula (a), an electrode having a low specific resistance can be more reliably formed by heat treatment at a low temperature (for example, 150 degrees C or lower).

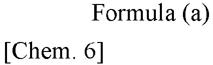

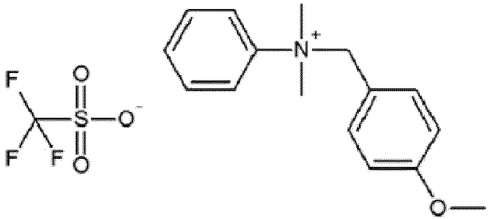

The conductive composition of the present embodiment preferably contains a compound having a structure of formula (b) as the curing agent (D). The compound having the structure of the formula (b) is a liquid phenolic resin. Since the curing agent (D) is the compound having the structure of the formula (b), an electrode having a low specific resistance can be more reliably formed by heat treatment at a low temperature (for example, 150 degrees C or lower). 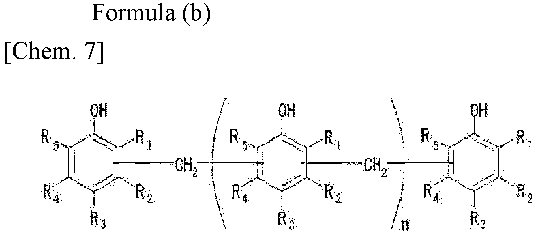 (In the formula, n represents 0 to 3, and R₁ to R₅ represent a hydrogen atom, a hydroxyl group, or an allyl group.)

In the conductive composition of the present embodiment, the ratio of the weight of the conductive particles (A) to the total weight of the epoxy resin (C) and the curing agent (D) (the weight of the conductive particles (A) : the total weight of the epoxy resin (C) and the curing agent (D)) is preferably 98.5 : 1.5 to 90.0 : 10.0, and preferably 98.0 : 2.0 to 92.0 : 8.0. By appropriately controlling the ratio of the weight of the conductive particles (A) and the total weight of the epoxy resin (C) and the curing agent (D), it is possible to form an electrode having a low specific resistance and a reduced possibility of disconnection.

In the conductive composition of the present embodiment, when the total weight of the conductive particles (A) and the epoxy resin (C) is 100 parts by weight, the conductive composition preferably contains 0.1 to 5.0 parts by weight of the curing agent (D), more preferably 0.15 to 3.5 parts by weight, and more preferably 0.2 to 2.0 parts by weight. By setting the weight ratio of the curing agent (D) in the predetermined range, it is possible to appropriately cure the epoxy resin (C) and obtain an electrode having a desired shape.

### <Other Components>

The conductive composition of the present embodiment can contain the following components in addition to the components (A), (B), (C), and (D) described above.

The conductive composition of the present embodiment can contain thermosetting resins other than the epoxy resins. Examples of such thermosetting resins include amino resins such as urea resins, melamine resins, and guanamine resins; oxetane resins; phenolic resins such as resol type phenolic resins, alkyl resol type phenolic resins, novolak type phenolic resin, alkyl novolak type phenolic resin, and aralkyl novolak type phenolic resin; silicone-modified resins such as silicone epoxy and silicone polyester; bismaleimide, and polyimide resins.

The conductive composition of the present embodiment may contain a thermoplastic resin other than the epoxy resin (C). Examples of thermoplastic resins other than the epoxy resins (C) include novolak type phenolic resin, allyl phenolic resin, phenoxy resin, butyral resin, cellulose resin, acrylic resin, methacrylic resin, polyester resin, polyurethane resin, polyamide resin, thermoplastic xylene resin, hydroxystyrene polymer, cellulose derivative, and mixtures of two or more of these resins.

The conductive composition of the present embodiment preferably further contains phenoxy resin (E). When the conductive composition of the present embodiment further contains phenoxy resin, thermosetting of the thermosetting resin at a low temperature (e.g., 150 degrees C or lower) can be more reliably achieved.

The conductive composition of the present embodiment preferably further contains a coupling agent (F). A silane coupling agent can be used as the coupling agent (F). When the conductive composition further contains the coupling agent (F), adhesion between inorganic components such as conductive particles and the thermosetting resin can be improved more.

The conductive composition of the present embodiment may further include at least one selected from the group consisting of inorganic pigment, organic pigment, leveling agent, thixotropic agent, and antifoaming agent.

### <Conductive paste>

A conductive paste of the present embodiment includes the conductive composition of the present embodiment described above. The conductive composition of the present embodiment can be used as a conductive paste. By using the conductive paste (the conductive composition) of the present embodiment, an electrode having a low specific resistance can be formed at a low temperature. Therefore, the conductive composition of the present embodiment can be preferably used as a conductive paste (a conductive composition) for forming an electrode of a solar cell.

The conductive paste of the present embodiment can be preferably used as a conductive paste for forming an electrode of a perovskite solar cell. This is because it is necessary to form the electrode of the perovskite solar cell at a low temperature (for example, 150 degrees C or lower) in order to avoid deterioration due to heating of the perovskite compound layer.

The method for producing the conductive paste of the present embodiment is not particularly limited. The conductive paste of the present embodiment can be produced by pouring each component in predetermined proportion into a mixer such as a grinding kneader, a propeller stirrer, a kneader, a three-roll mill, a pot mill and the like, and mixing them.

The conductive paste of the present embodiment can be applied to a surface of a transparent electrode and the like by a known method such as a screen printing method. After the conductive paste is applied to a surface of a transparent electrode and the like, the conductive paste is heated to a predetermined temperature and cured to form a conductive film (electrode).

In the present specification, the conductive film, the electrode, and the like obtained by heating and curing the conductive composition of the present embodiment or the conductive paste of the present embodiment at a predetermined temperature are referred to as a "cured product". The cured product of the present embodiment is a cured product of the conductive composition or the conductive paste described above. The cured product of the present embodiment can be preferably used as an electrode of a solar cell (for example, an electrode of a perovskite solar cell).

The cured product of the present embodiment is preferably a cured product obtained by applying a conductive composition or a conductive paste to a surface of a transparent conductive film and curing it at 110 degrees C for 45 minutes. The specific resistance of the electrode of the solar cell is preferably 15 µΩ·cm or less, more preferably 12 µΩ·cm or less, and further more preferably 10 µΩ·cm or less. The cured product of the present embodiment has a contact resistance between the cured product (for example, an electrode) and the transparent conductive film, and the contact resistance can be, for example, 65 mΩ·cm² or less, preferably 60 mΩ·cm² or less, more preferably 30 mΩ·cm² or less, further more preferably 20 mΩ·cm² or less, and further more preferably 10 mΩ·cm² or less. Because the electrode that is the cured product of the present embodiment has such characteristics, the electrode of the cured product of the present embodiment can be preferably used as an electrode of a perovskite solar cell.

In the case of the conductive paste for forming the electrode of the perovskite solar cell, the heat treatment temperature for thermally curing a conductive paste (heat treatment temperature for forming an electrode of the solar cell) is preferably 150 degrees C or less, and more preferably 130 degrees C or less. Specifically, the heat treatment temperature for thermally curing the conductive paste is preferably 100 to 150 degrees C, and more preferably 100 to 130 degrees C. The heat treatment time is preferably 20 to 60 minutes, and more preferably 25 to 45 minutes. A specific example of the heat treatment condition is 110 degrees C for 45 minutes.

The thickness of the conductive paste applied to the surface of the transparent electrode or the like is preferably 5 to 40 µm, more preferably 10 to 30 µm, and further more preferably 15 to 20 µm.

The conductive paste of the present embodiment can be preferably used to form an electrode of a solar cell having a wiring width of 20 to 60 µm. Therefore, the electrode of the solar cell obtained by heat-treating the conductive paste of the present embodiment can include an electrode having a wiring width of 20 to 60 µm. The width (wiring width) of the conductive paste applied to the surface of the transparent electrode or the like is preferably 20 to 60 µm, more preferably 20 to 50 µm, and further more preferably 20 to 40 µm.

The conductive film obtained by heating the conductive paste of the present embodiment has features of high adhesion strength to the substrate, low specific resistance (high conductivity), and low contact resistance. Therefore, by using the thermosetting conductive paste of the present embodiment, it is possible to form a good electrode for the semiconductor device or the like without causing the semiconductor device or the like to deteriorate due to high temperature.

The conductive paste of the present embodiment can be used to form an electrode and a circuit pattern of a semiconductor device and an electronic component, and the like. The conductive paste of the present embodiment can be used to form an electrode and/or a circuit pattern not only on a surface of an inorganic material such as a semiconductor, an oxides and a ceramic, but also on a substrate with low heat resistance such as PET (polyethylene terephthalate) and PEN (polyethylene naphthalate).

The term a "semiconductor device" as used herein means a device using a semiconductor chip, for example, a semiconductor device such as a transistor and an integrated circuit, a flat panel display such as a liquid crystal display (LCD) and a plasma display panel (PDP), and a device using a semiconductor such as a solar cell. A semiconductor device is a device using the properties of electrons and/or holes in a semiconductor and has electrodes for direct or indirect electrical connection to the semiconductor.

In some cases, the electrodes of a semiconductor device require light transmission. A transparent conductive film is used as a material for such electrodes. An electrode made of a transparent conductive film is called a transparent electrode. The transparent electrodes are used in flat panel displays such as liquid crystal displays (LCD) and plasma display panels (PDP), and semiconductor devices such as various solar cells. Examples of a solar cell includes a thin film solar cell such as a perovskite solar cell, an amorphous silicon solar cell, and a compound semiconductor solar cell (a CIS (CuInSe₂) solar cell, a CIGS (Copper Indium Gallium Selenide) solar cell, and a CdTe solar cells, etc.), a heterojunction solar cell, and a crystalline silicon solar cell. The transparent electrode is used to form an electrode such as a flat panel display, a thin film solar cell including a perovskite solar cell, and a heterojunction solar cell, and the like.

An oxide conductive film can be used as a transparent conductive film that is a material of the transparent electrode. Examples of the oxide conductive film include an indium tin oxide (also referred to "ITO (Indium Tin Oxide)".) thin film, a tin oxide thin film, and a ZnO-based thin film. At present, ITO thin films are widely used in flat panel displays, various solar cells, and the like. A finger-shaped or a grid-shaped electrode (it is sometimes simply referred to as an "electrode".) is formed for connecting electrically to the transparent electrode so as not to prevent light from entering or leaving the semiconductor device. The conductive composition (the conductive paste) of the present embodiment can be used to form a finger electrode (a finger-shaped or a grid-shaped electrode) on the surface of the transparent electrode.

The semiconductor chip and/or other materials may deteriorate when processing is performed at a high temperature, for example, at a temperature exceeding 150 degrees C, in the step of electrode formation, depending on the type of the material of the semiconductor of the semiconductor device, the type of the material of the electronic component, and the type of the material other than the semiconductor constituting the semiconductor device, the electronic component or the like. By using the conductive paste of the present embodiment, it is possible to form an electrode having a low specific resistance at a low temperature (for example, 150 degrees C or lower). By using the conductive paste of the present embodiment, it is possible to form an electrode having a predetermined low resistance without the semiconductor device deteriorating at a high temperature. Therefore, the conductive composition of the present embodiment can be preferably used as a conductive paste for forming an electrode of a perovskite solar cell in particular.

When an electrode is formed on a transparent conductive film using the conductive composition (the conductive paste) of the present embodiment, a low contact resistance can be obtained. In particular, when an electrode is formed on an ITO thin film, a low contact resistance (for example, a contact resistance of 70 mΩ·cm² or less) can be obtained relatively easily. Therefore, the conductive paste of the present embodiment can be preferably used for forming an electrode (especially a finger electrode) on a transparent conductive film, particularly an ITO thin film. The conductive paste of the present embodiment can be particularly preferably used as a conductive paste for forming an electrode disposed on a surface of a transparent conductive film of a perovskite solar cell.

### <Solar cell>

The present embodiment is a solar cell containing the cured product of the conductive composition or the conductive paste described above. The cured product may be an electrode of a solar cell. By using the conductive composition or the conductive paste of the present embodiment, an electrode of a solar cell having a low specific resistance can be formed at a low temperature. Therefore, an adverse effect on the solar cell caused by a high temperature during the heat treatment at the time of electrode formation can be suppressed.

The conductive paste of the present embodiment can preferably be used to form an electrode on a surface of a transparent conductive film of a solar cell. Depending on a type of a solar cell, a material that is adversely affected by a high-temperature heating process may be used. In particular, in order to suppress deterioration of a perovskite compound layer of a perovskite solar cell, it is necessary that the heating temperature at the time of electrode formation is 150 degrees C or lower. The conductive paste of the present embodiment can preferably be used to form an electrode on a surface of a transparent conductive film of such a solar cell having low heat resistance. By using the conductive paste of the present embodiment, an electrode of a perovskite solar cell having a low specific resistance can be formed.

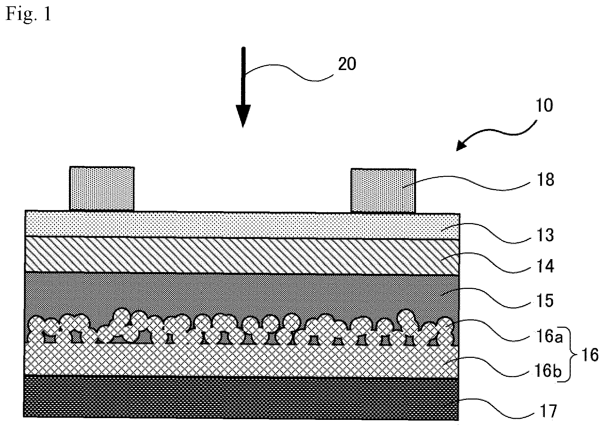

A perovskite solar cell that is a preferable application of the conductive paste of the present embodiment will be described with reference to Fig. 1.

Fig. 1 is a cross-sectional schematic diagram of an example of a perovskite solar cell 10. In the perovskite solar cell 10 shown in Fig. 1, a metal oxide layer 16 serving as an electron transport layer, a perovskite compound layer 15, a hole transport layer 14, and a first electrode 13 are layered in this order on one surface of a second electrode 17. Further, the perovskite solar cell 10 shown in Fig. 1 has a finger electrode 18 on the surface of the first electrode 13 that is a transparent conductive film. The conductive composition (the conductive paste) of the present embodiment can be used for forming the finger electrode 18. Since a specific resistance of the transparent conductive film is high, the electrical loss can be reduced by arranging the finger electrode 18. Incident light 30 enters from the surface of the first electrode 13 having the finger electrode 18, is absorbed by the perovskite compound layer 15 that is a photosensitizing layer, and generates holes and electrons, thereby generating electric power. The metal oxide layer 16 (e.g., a titanium oxide layer) may include a mesoporous metal oxide layer 16a and a compact metal oxide layer 16b. The second electrode 17 may be, for example, a flat plate made of metal. That is, in the perovskite solar cell 10 shown in Fig. 1, since the second electrode 17 is a flat plate made of metal having a certain degree of rigidity, structural strength can be maintained.

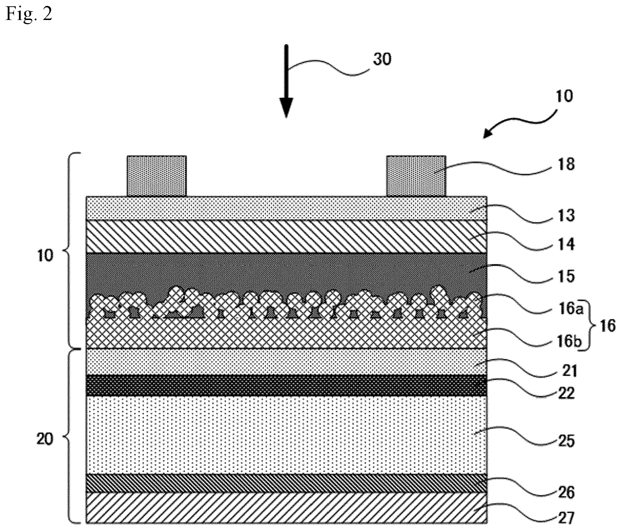

The perovskite solar cell 10 is not limited to the one illustrated in Fig. 1, but may be, for example, a tandem type perovskite solar cell (a tandem solar cell) in which a perovskite solar cell 10 is used as a top cell and, for example, a silicon heterojunction solar cell 20 is used as a bottom cell as shown in Fig.2. In the present specification, a solar cell including at least a perovskite compound layer 15 may be referred to as a "perovskite solar cell". In the tandem solar cell, a single crystalline silicon solar cell or a polycrystalline silicon solar cell may be used instead of the silicon heterojunction solar cell 20.

Fig. 2 is a cross-sectional schematic diagram of a tandem solar cell comprising the perovskite solar cell 10 shown in Fig. 1 and a silicon heterojunction solar cell 20 using amorphous silicon and a crystalline silicon substrate (a single crystalline silicon substrate or a polycrystalline silicon substrate). Since a band gap of silicon is about 1.1 eV, the crystalline silicon solar cell has high electric power generation efficiency with light of a relatively long wavelength among solar light. On the other hand, the perovskite solar cell 10 generates electric power with light of a relatively short wavelength among sunlight, and transmits light of a relatively long wavelength. Therefore, in the tandem solar cell shown in Fig.2, light of a relatively short wavelength among incident light 30 is absorbed by the perovskite solar cell 10 to generate electric power, and the silicon heterojunction solar cell 20 can generate electric power with absorbing light of a relatively long wavelength transmitted through the perovskite solar cell 10. Since the tandem solar cell shown in Fig. 2 can generate electric power by effectively utilizing incident light 30 of a wider wavelength range, a solar cell with high conversion efficiency can be obtained. The conductive composition (the conductive paste) of the present embodiment can be used for forming the finger electrode 18 arranged on the surface of the perovskite solar cell 10 of the tandem solar cell.

The silicon heterojunction solar cell 20 cell of the tandem solar cell shown in Fig. 2 has a p-type amorphous silicon layer 22 on one surface of an n-type silicon substrate 25 (a n-type single crystalline silicon substrate or a n-type polycrystalline silicon substrate), and an n-type impurity diffusion layer 26 and a back electrode 27 on the other surface. An interface layer 21 having conductivity can be arranged between the perovskite solar cell 10 and the silicon heterojunction solar cell 20. In order to generate electric power in the silicon heterojunction solar cell 20, the interface layer 21 needs to transmit light of a relatively long wavelength out of the incident light 30 that has not been absorbed by the perovskite solar cell 10. Therefore, the material of the interface layer 21 is preferably a transparent conductive film (for example, a tin oxide thin film and an indium tin oxide (ITO) thin film).

In the perovskite solar cell 10 shown in Fig. 1 and the perovskite solar cell 10 of the tandem solar cell shown in Fig.2, the finger electrode 18 having a low specific resistance and a low contact resistance can be formed with a relatively low temperature (for example, 150 degrees C or lower) by using the conductive composition (the conductive paste) of the present embodiment, in a step after the formation of the perovskite compound layer 15. Therefore, the perovskite solar cell 10 and the tandem solar cell including the perovskite solar cell 10, which have high performance, can be obtained by forming the finger electrode 18 using the conductive composition (the conductive paste) of the present embodiment. Therefore, the cured product of the conductive composition (the conductive paste) of the present embodiment can preferably be used as the electrode (particularly, the electrode formed on a transparent conductive film such as an ITO thin film) of the perovskite solar cell 10 or the tandem solar cell including the perovskite solar cell 10.

### EXAMPLE

Examples and Comparative examples of the present embodiment will be described below. The present embodiment is not limited to the following Examples and Comparative examples.

### [Preparation of conductive paste]

As Examples and Comparative examples, a conductive paste containing conductive particles (A), a solvent (B), an epoxy resin (C) and a curing agent (D), and optionally containing a phenoxy resin (E) and a silane (F) coupling agent, was prepared. Tables 1 to 4 shows the proportions of Examples 1 to 21 and Comparative Examples 1 to 4. The proportions shown in Tables 1 to 4 are expressed as parts by weight when the weight of the conductive particles (A) is 100 parts by weight.

The following particles A1 and A2 were used as the conductive particles (A).
• Particle A1: Silver particles manufactured by DOWA, product name "AG-SNA - 458", spherical in shape, particle size (D50) 0.5 µm, TAP density 4.3 g/cm³, BET specific surface area 1.6 m²/g.
• Particle A2: Silver particles manufactured by DOWA, product name "AG-SNA - 431", spherical in shape, particle size (D50) 2.5 µm, TAP density 6.0 g/cm³, BET specific surface area 0.3 m²/g.

The following solvents B1 and B2 were used as the solvents (B).
• Solvent B1: Diethylene glycol monobutyl ether
• Solvent B2: Diethylene glycol monobutyl ether acetate

The following resins C1 to C9 were used as the epoxy resins (C). Resin C6 is epoxy resin "AK-601" (trade name) manufactured by Nippon Kayaku Co., Ltd (diglycidyl 1,2-cyclohexanedicarboxylate, see Formula (4)). Resins C1 to C5 are epoxy resins containing a low concentration of the easily saponifiable chlorine component by distilling AK-601 (trade name) using an evaporator. Resins C7 and C8 are epoxy resins containing a high concentration of the easily saponifiable chlorine component generated as a by-product when AK-601 (trade name) is distilled. In Tables 1 to 4, the concentration of the easily saponifiable chlorine is a weighted average concentration of the easily saponifiable chlorine of the multiple epoxy resins (C) when more than one of epoxy resins (C) are used.
• Resin C1: Concentration of the easily saponifiable chlorine: 1200 ppm
• Resin C2: Concentration of the easily saponifiable chlorine: 1500 ppm
• Resin C3: Concentration of the easily saponifiable chlorine: 3500 ppm
• Resin C4: Concentration of the easily saponifiable chlorine: 4500 ppm
• Resin C5: Concentration of the easily saponifiable chlorine: 5500 ppm
• Resin C6: Concentration of the easily saponifiable chlorine: 6000 ppm
• Resin C7: Concentration of the easily saponifiable chlorine: 9200 ppm
• Resin C8: Concentration of the easily saponifiable chlorine: 22000 ppm
• Resin C9: Epoxy resin "EXA 835LV (trade name)" manufactured by Dainippon Ink Co., Ltd (a mixture of bisphenol A type epoxy resin and bisphenol F type epoxy resin), concentration of the easily saponifiable chlorine: 40 ppm

The diglycidyl 1,2-cyclohexanedicarboxylate of the resins C1 to C8 is a compound having a structure represented by formula (4) below.

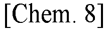

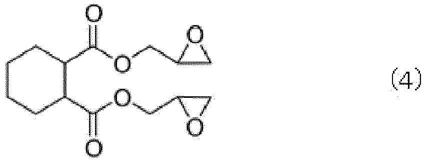

The following curing agents D1 to D3 were used as the curing agents (D). The curing agent D1 is a compound having a structure of formula (b), and the curing agent D2 is a compound having a structure of formula (a).
• Curing agent D 1: Phenol resin of formula (b), product name "MEH-8000H" manufactured by Meiwa Kasei Co., Ltd. 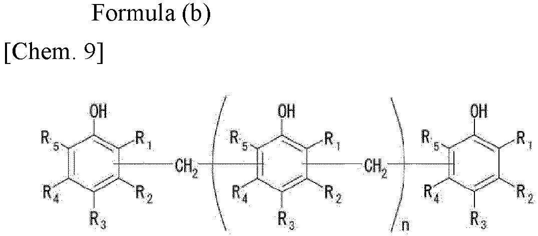 (In the formula, n represents 0 to 3, and R₁ to R₅ represent a hydrogen atom, a hydroxyl group, or an allyl group.)
• Curing agent D2: Cationic polymerization initiator of formula (a), product name "CXC1614" manufactured by King Industries, Inc. 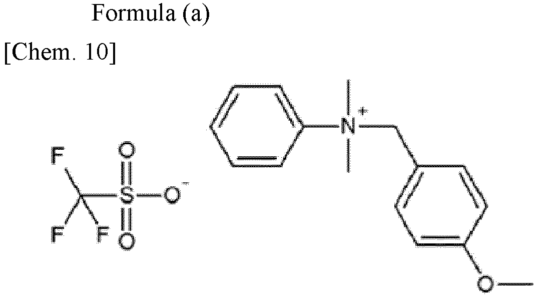
• Curing agent D3: Cationic polymerization initiator, product name "CXC1612" manufactured by King Industries, Inc.

Product name "PKHH" manufactured by GABRIEL was used as the phenoxy resin (E).

Product name "KBM-403" manufactured by Shin-Etsu Chemical Co., Ltd. was used as the silane coupling agent (F).

### [Measurement of specific resistance]

The specific resistance of the conductive films obtained by heating the conductive pastes of Examples and Comparative Examples was measured.

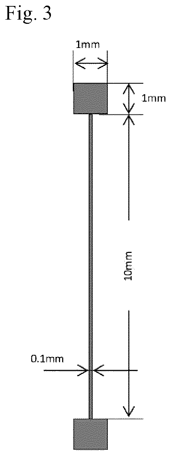

The specific resistance of Examples and Comparative Examples was measured by the following procedure. That is, a single crystalline silicon substrate having a width of 15 mm, a length of 15 mm, and a thickness of 180 µm was prepared. A pattern consisting of the conductive paste as shown in Fig. 3 was printed on the substrate using a 325 mesh stainless steel screen.

Next, the pattern consisting of the conductive paste of Examples and Comparative Examples applied on the substrate was heated at 110 degrees C for 45 minutes to obtain a sample for the measurement of the specific resistance.

The specific resistance of the conductive film patterns of the samples for the measurements of the specific resistance obtained by heating the conductive pastes of Examples and Comparative Examples were measured. First, the resistance value was measured by the 4-terminal method using a multimeter type 2001 manufactured by Toyo Corporation. The cross-sectional area of the pattern was measured using a confocal microscope OPTELICS H1200 manufactured by Lasertec Corporation and surface roughness profiler 1500SD2. Fifty places in a range of 1.6 mm were measured, and the average value was obtained. The specific resistance was calculated with the cross-sectional area and the measured resistance value.

Four samples of the same condition were prepared as the samples for resistivity measurement, and the measured values were obtained as the average values of the four samples. The measurement results are shown in Tables 1 to 4.

As is clear from Tables 1 to 4, the specific resistance of the conductive film obtained by using the conductive paste (the conductive composition) of Examples 1 to 21 of the present embodiment was 14.8 µΩ·cm (Examples 11 and 18) or less. In general, it can be said that a specific resistance of 15 µΩ·cm or less can be suitably used as an electrode. In contrast, the specific resistance of the conductive film obtained by using the conductive paste of Comparative Examples 1 to 4 ranged from 15.7 µΩ·cm (Comparative Example 1) to 1960 µΩ·cm (Comparative Example 4). Therefore, it became clear that a lower specific resistance can be obtained by forming conductive films (electrodes) using the conductive pastes (the conductive compositions) of Examples 1 to 21 of the present embodiment.

### [Measurement of contact resistance]

An electrode was formed on a surface of a crystalline silicon substrate having a transparent conductive film using the conductive pastes of Examples and Comparative Examples, and the contact resistance was measured. Specifically, the contact resistance measurement pattern using the conductive paste of Examples 1 to 21 and Comparative Examples 1 to 4 was screen printed on the transparent conductive film formed on the surface of the crystalline silicon substrate, and heated to obtain the electrode for the contact resistance measurement.

An n-type single crystalline silicon substrate (substrate thickness 200 µm) was used as the substrate.

Next, a transparent conductive film was formed on the surface of the n-type single crystalline silicon substrate. Specifically, an indium tin oxide thin film (an ITO thin film) was formed by sputtering using a sputtering target containing indium oxide and tin oxide. The sheet resistance of the obtained ITO thin film was 80 Ω/square. The substrate for the contact resistance measurement thus obtained was used for forming an electrode for the contact resistance measurement.

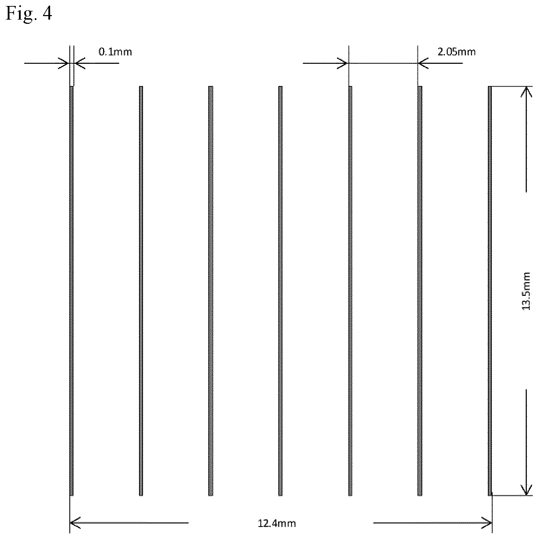

The conductive paste was printed by the screen printing method on the substrate for the contact resistance measurement. A contact resistance measurement pattern was printed on the substrate so that the film thickness was about 30 µm, and then heated at 110 degrees C for 45 minutes to obtain a sample for the contact resistance measurement. Fig. 4 shows a plan diagram illustrating a pattern used for measuring the contact resistance. The pattern for the contact resistance measurement shown in Fig. 4 is a pattern in which 7 rectangular electrode patterns with a width of 0.1 mm and a length of 13.5 mm are arranged so that the pitch interval is 2.05 mm.

Three samples of the same condition were prepared as the samples for the contact resistance measurement, and the measured value was obtained as the average value of the three samples.

The contact resistance was obtained by the TLM method (Transfer Length Method) using GP 4TEST Pro manufactured by GP Solar to obtain the electric resistance between predetermined rectangular electrode patterns shown in Fig. 4. When the contact resistance is 65 mΩ·cm² or less, it can be used as an electrode on a transparent conductive film. When the contact resistance is 60 mΩ·cm² or less, it can be more preferably used as an electrode on a transparent conductive film.

As is clear from Tables 1 to 4, the contact resistance of the conductive film obtained using the conductive paste of Examples 1 to 21 to the transparent conductive film (ITO thin film) is 63.1 mΩ·cm² (Example 1) or less. Therefore, it can be said that the contact resistance of Examples 1 to 21 is within the numerical range that can be used as an electrode on a transparent conductive film.

The contact resistance of a conductive film, obtained using the conductive paste of Examples 2 to 21 using two kinds of the conductive particles A1 and A2, to the transparent conductive film (ITO thin film) is 59.5 mΩ·cm² (Examples 5 and 8) or less, which is 60 mΩ·cm² or less. Therefore, it is clear that a lower contact resistance can be obtained by using two kinds of the conductive particles A1 and A2. Therefore, the conductive paste containing two kinds of the conductive particles A1 and A2 can be more preferably used as an electrode on a transparent conductive film.

On the other hand, the contact resistance of a conductive film (an electrode), obtained using the conductive paste of Comparative Example 2 in which the amount of epoxy resin (C) is 15 parts by weight based on 100 parts by weight of the conductive particles (A), to the transparent conductive film (ITO thin film) is as high as 94 µΩ·cm². Further, the contact resistance of the conductive film, obtained by using the conductive paste of Comparative Example 4 in which the concentration of the easily saponifiable chlorine of the epoxy resin (C) was 1600 ppm, to the transparent conductive film (ITO thin film) was very high and could not be measured. Therefore, "-" was indicated in the" contact resistance" column of Comparative Example 4 in Table 1.

The conductive paste of Comparative Example 1, in which the epoxy resin (C) was 1 part by weight based on 100 parts by weight of the conductive particles (A), had a high specific resistance of 15.7 µΩ·cm, although the contact resistance was low. The conductive paste of Comparative Example 3, in which the concentration of the easily saponifiable chlorine of the epoxy resin (C) was 1200, had a high specific resistance of 156 µΩ·cm, although the contact resistance was low. Therefore, it can be said that it is difficult to use the conductive paste of Comparative Examples 1 and 3 as a conductive paste for solar cells.

From the above, it is clear that an electrode having a low specific resistance and a low contact resistance of a perovskite solar cell can be formed at a low temperature (for example, 150 degrees C or lower) by using the conductive paste (the conductive composition) of the present embodiment.

**Table 1**

| (Weight part) | | Comparative Example 1 | Comparative Example 2 | Comparative Example 3 | Comparative Example 4 | Example 1 | Example 2 | Example 3 |
|---|---|---|---|---|---|---|---|---|
| Conductive particle (A) | Particle A1 | 25.0 | 25.0 | 25.0 | 25.0 | | 25.0 | 25.0 |
| | Particle A2 | 75.0 | 75.0 | 75.0 | 75.0 | 100.0 | 75.0 | 75.0 |
| Solvent (B) | Solvent B1 | 2.6 | 2.6 | 2.6 | 2.6 | 2.6 | 2.6 | 2.6 |
| | Solvent B2 | | | | | | | |
| Epoxy Resin (C) | Resin C1 | | | 7.4 | | | | |
| | Resin C2 | | | | 1.6 | | | |
| | Resin C3 | | | | | | | |
| | Resin C4 | | | | | | | |
| | Resin C5 | | | | | | | |
| | Resin C6 | 1.0 | 150 | | | 4.0 | 1.4 | 1.6 |
| | Resin C7 | | | | | | | |
| | Resin C8 | | | | | | | |
| | Resin C9 | | | | | | | |
| Curing agent (D) | Curing agent D1 | 0.7 | 0.7 | 0.7 | 0.7 | 0.7 | 0.7 | 0.7 |
| | Curing agent D2 | 0.3 | 0.3 | 0.3 | 0.3 | 0.3 | 0.3 | 0.3 |
| | Curing agent D3 | | | | | | | |
| Phenoxy resin (E) | | 0.2 | 0.2 | 0.2 | 0.2 | 0.2 | 0.2 | 0.2 |
| Silane coupling agent (F) | | 1.1 | 1.1 | 1.1 | 1.1 | 1.1 | 1.1 | 1.1 |
| Total of epoxy resin (C) (parts by weight) | | 1.0 | 150 | 7.4 | 1.6 | 4.0 | 1.4 | 1.6 |
| Concentration of easily saponifiable chlorine of total epoxy resins (ppm) | | 6000 | 6000 | 1200 | 1500 | 6000 | 6000 | 6000 |
| Specific Resistance (µΩ·cm) | | 15.7 | 19.1 | 156 | 1960 | 8.3 | 12.2 | 10.7 |
| Contact Resistance (mΩ·cm²) | | 4.2 | 94.0 | 14.4 | - | 63.1 | 6.5 | 8.3 |

**Table 2**

| (Weight part) | | Example 4 | Example 5 | Example 6 | Example 7 | Example 8 | Example 9 | Example 10 |
|---|---|---|---|---|---|---|---|---|
| Conductive particle (A) | Particle A1 | 25.0 | 25.0 | 25.0 | 25.0 | 25.0 | 25.0 | 25.0 |
| | Particle A2 | 75.0 | 75.0 | 75.0 | 75.0 | 75.0 | 75.0 | 75.0 |
| Solvent (B) | Solvent B1 | 2.6 | 2.6 | 2.6 | | 2.6 | 2.6 | 2.6 |
| | Solvent B2 | | | | 2.6 | | | |
| Epoxy Resin (C) | Resin C1 | | | | | | | |
| | Resin C2 | | | | | | | |
| | Resin C3 | | | | | | | |
| | Resin C4 | | | | | | | |
| | Resin C5 | | | | | | | |
| | Resin C6 | 4.0 | 4.0 | 4.0 | 4.0 | 7.4 | | |
| | Resin C7 | | | | | | 1.6 | |
| | Resin C8 | | | | | | | 1.6 |
| | Resin C9 | | | | | | | |
| Curing agent (D) | Curing agent D1 | 0.7 | 0.7 | 0.7 | 0.7 | 0.7 | 0.7 | 0.7 |
| | Curing agent D2 | 0.3 | 0.3 | 0.3 | 0.3 | 0.3 | 0.3 | 0.3 |
| | Curing agent D3 | | | | | | | |
| Phenoxy resin (E) | | 0.2 | | 0.2 | 0.2 | 0.2 | 0.2 | 0.2 |
| Silane coupling agent (F) | | | 1.1 | 1.1 | 1.1 | 1.1 | 1.1 | 1.1 |
| Total of epoxy resin (C) (parts by weight) | | 4.0 | 4.0 | 4.0 | 4.0 | 7.4 | 1.6 | 1.6 |
| Concentration of easily saponifiable chlorine of total epoxy resins (ppm) | | 6000 | 6000 | 6000 | 6000 | 6000 | 9200 | 22000 |
| Specific Resistance (µΩ·cm) | | 9.1 | 7.3 | 6.6 | 6.7 | 7.9 | 7.1 | 4.7 |
| Contact Resistance (mΩ·cm²) | | 55.6 | 59.5 | 51.0 | 55.0 | 59.5 | 15.4 | 34.8 |

**Table 3**

| (Weight part) | | Example 11 | Example 12 | Example 13 | Example 14 | Example 15 | Example 16 | Example 17 |
|---|---|---|---|---|---|---|---|---|
| Conductive particle (A) | Particle A1 | 35.0 | 20.0 | 25.0 | 25.0 | 25.0 | 25.0 | 25.0 |
| | Particle A2 | 65.0 | 80.0 | 75.0 | 75.0 | 75.0 | 75.0 | 75.0 |
| Solvent (B) | Solvent B1 | 2.6 | 2.6 | 2.6 | 2.6 | 2.6 | 2.6 | 1.5 |
| | Solvent B2 | | | | | | | |
| Epoxy Resin (C) | Resin C1 | | | | | | | |
| | Resin C2 | | | | | | | |
| | Resin C3 | | | | | | | |
| | Resin C4 | | | | | | | |
| | Resin C5 | | | | | | | |
| | Resin C6 | 1.6 | 1.6 | | 0.9 | 0.6 | | |
| | Resin C7 | | | 1.3 | | | | 2.1 |
| | Resin C8 | | | | 0.3 | 0.6 | 1.3 | |
| | Resin C9 | | | 0.8 | 0.8 | 0.8 | 0.8 | 2.4 |
| Curing agent (D) | Curing agent D1 | 0.7 | 0.7 | 0.7 | 0.7 | 0.7 | 0.7 | |
| | Curing agent D2 | 0.0 | 0.3 | 0.3 | 0.3 | 0.3 | 0.3 | 0.4 |
| | Curing agent D3 | | | | | | | |
| Phenoxy resin (E) | | 0.2 | 0.2 | 0.2 | 0.2 | 0.2 | 0.2 | |
| Silane coupling agent (F) | | 1.1 | 1.1 | 1.1 | 1.1 | 1.1 | 1.1 | 1.1 |
| Total of epoxy resin (C) (parts by weight) | | 1.6 | 1.6 | 2.0 | 2.0 | 2.0 | 2.0 | 4.5 |
| Concentration of easily saponifiable chlorine of total epoxy resins (ppm) | | 6000 | 6000 | 5706 | 6201 | 8675 | 13624 | 4300 |
| Specific Resistance (µΩ·cm) | | 14.8 | 7.6 | 100 | 9.0 | 8.0 | 6.5 | 11.9 |
| Contact Resistance (mΩ·cm²) | | 9.8 | 14.7 | 9.1 | 9.1 | 11.8 | 30.7 | 150 |

**[Table 4]**

| (Weight part) | | Example 18 | Example 19 | Example 20 | Example 21 |
|---|---|---|---|---|---|
| Conductive particle (A) | Particle A1 | 25.0 | 25.0 | 25.0 | 25.0 |
| | Particle A2 | 75.0 | 75.0 | 75.0 | 75.0 |
| Solvent (B) | Solvent B1 | 2.6 | 2.6 | 2.6 | 2.6 |
| | Solvent B2 | | | | |
| Epoxy Resin (C) | Resin C1 | | | | |
| | Resin C2 | | | | |
| | Resin C3 | 1.6 | | | |
| | Resin C4 | | 1.6 | | |
| | Resin C5 | | | 1.6 | |
| | Resin C6 | | | | |
| | Resin C7 | | | | |
| | Resin C8 | | | | 4.0 |
| | Resin C9 | | | | |
| Curing agent (D) | Curing agent D1 | 0.7 | 0.7 | 0.7 | 0.7 |
| | Curing agent D2 | 0.3 | 0.3 | 0.3 | |
| | Curing agent D3 | | | | 0.3 |
| Phenoxy resin (E) | | 0.2 | 0.2 | 0.2 | 0.2 |
| Silane coupling agent (F) | | 1.1 | 1.1 | 1.1 | 1.1 |
| Total of epoxy resin (C) (parts by weight) | | 1.6 | 1.6 | 1.6 | 4.0 |
| Concentration of easily saponifiable chlorine of total epoxy resins (ppm) | | 3500 | 4500 | 5500 | 22000 |
| Specific Resistance (µΩ·cm) | | 14.8 | 13.8 | 14.5 | 6.6 |
| Contact Resistance (mΩ·cm²) | | 9.9 | 10.3 | 9.6 | 16.7 |

### Description of Reference Numerals

10: Perovskite Solar Cells
12: Glass Substrate
13: First Electrode (Transparent Conductive Film)
14: Hole Transport Layer
15: Perovskite compound layer
16: Metal oxide layer
16a: Mesoporous metal oxide layer
16b: Compact metal oxide layer
17: Second electrode
18: Finger electrode
20: Silicon heterojunction solar cell
21: Interface layer
22: p-type amorphous silicon layer
25: n-type silicon substrate
26: n-type impurity diffusion layer
27: Back electrode
30: Incident light

## Claims

1. A conductive composition comprising:
conductive particles (A);
a solvent (B); and
an epoxy resin (C),
wherein the epoxy resin (C) has a concentration of easily saponifiable chlorine of 1600 ppm or more, and
the epoxy resin (C) is 1.2 to 10 parts by weight based on 100 parts by weight of the conductive particles (A).

2. The conductive composition according to claim 1, wherein the conductive particles (A) comprises conductive particles A1 and conductive particles A2, and an average particle size of the conductive particles A2 is larger than an average particle size of the conductive particles A1.

3. The conductive composition according to claim 2, wherein the average particle size of the conductive particles A2 is 1.5 to 4.5 µm.

4. The conductive composition according to claim 2 or 3, wherein
an average particle size of the conductive particles A1 is 0.05 to 1.4 µm, and
an average particle size of the conductive particles A2 is 2.0 to 3.5 µm.

5. The conductive composition according to any one of claims 2 to 4, wherein the conductive particles (A) comprise 0 to 40 weight % of the conductive particles A1 and 40 to 90 weight % of the conductive particles A2 in 100 weight % of the conductive particles (A).

6. The conductive composition according to any one of claims 2 to 5, wherein the conductive particles A1 have a BET specific surface area of 0.3 to 3.5 m²/g.

7. The conductive composition according to any one of claims 2 to 6, wherein the conductive particles A2 have a BET specific surface area of 0.1 to 0.4 m²/g.

8. The conductive composition according to any one of claims 2 to 7, wherein the conductive particles (A1) and the conductive particles (A2) are spherical conductive particles.

9. The conductive composition according to any one of claims 1 to 8, wherein the conductive composition further comprises a curing agent (D).

10. The conductive composition of claim 9, wherein the curing agent (D) comprises a compound of the structure of formula (a).

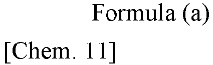

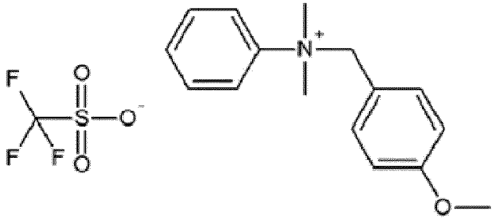

11. A conductive paste for forming an electrode of a solar cell, wherein the conductive paste comprises the conductive composition according to any one of claims 1 to 10.

12. A conductive paste for forming an electrode of a perovskite solar cell, wherein the conductive paste comprises the conductive paste according to claim 11.

13. A cured product of the conductive composition according to any one of claims 1 to 10, or a cured product of the conductive paste according to claim 11 or 12.

14. A solar cell comprising the cured product according to claim 13.
